# EUROPEAN PATENT SPECIFICATION

(11) **EP 0 953 207 B1**
(45) Date of publication and mention of the grant of the patent: **16.08.2001**
(21) Application number: 97950330.7
(22) Date of filing: 24.12.1997
(51) Int. Cl.: H01L 21/607, H01L 21/603

(54) **METHOD FOR DOPING METALLIC CONNECTING WIRE**
VERFAHREN ZUM DOTIEREN EINES METALLISCHEN VERBINDUNGSDRAHTES
PROCEDE DE DOPAGE D'UN FIL DE CONNEXION METALLIQUE

(30) Priority: 16.01.1997 US 784213
(43) Date of publication of application: 03.11.1999
(73) Proprietor: Ford Motor Company, Dearborn, MI 48126 (US); FORD MOTOR COMPANY LIMITED, Brentwood, Essex CM13 3BW (GB)
(72) Inventor: PHAM, Cuong, Van, Belleville,MI 48111 (US); BAKER, Jay, DeAvis, West Bloomfield, MI 48323 (US); NUNO, Rose, Lynda, Canton, MI 48187 (US)
(74) Representative: Messulam, Alec Moses
(86) International application number: GB9703544
(87) International publication number: WO9832168

(56) References cited:
- EP-A- 0 288 776
- EP-A- 0 365 919
- US-A- 3 561 084
- US-A- 3 942 187
- US-A- 4 842 662
- US-A- 5 455 195
- US-A- 5 514 912
- S. KH. MIL'STEIN ET AL: "A Low-Stress Low-Temperature "Micro-Soldering" Technique for Making Electrical Contacts to Semiconductor Crystals and Thin Film Materials" IEEE TRANSACTIONS ON COMPONENTS,HYBRIDS,AND MANUFACTURING TECHNOLOGY., vol. CHMT-8, no. 3, September 1985, NEW YORK US, pages 397-402, XP002059600
- B. L. GEHMAN: "Bonding Wire Microelectronic Interconnections" IEEE TRANSACTIONS ON COMPONENTS,HYBRIDS,AND MANUFACTURING TECHNOLOGY., vol. CHMT-3, no. 3, September 1980, NEW YORK US, pages 375-383, XP002059601
- PATENT ABSTRACTS OF JAPAN vol. 008, no. 268 (E-283), 7 December 1984 & JP 59 139661 A (HITACHI SEISAKUSHO KK), 10 August 1984,

## Description

The present invention relates generally to integrated circuits. More specifically, the present invention relates to a method for on-line doping of metallic connecting wire for use in wire bonding and wire bumping of integrated circuit components.

In the field of integrated circuit (IC) devices, a wide variety of packaging types and configurations are available to meet the various needs of circuit designers. However, despite such variety, most IC devices are constructed according to one of two closely related types of structures. The first of these structures comprises: (1) a silicon-based IC die which carries the discrete circuitry of the device, the die having input/output (I/O) pads situated along two or more of its peripheral edges or across an entire face; (2) an encapsulation for carrying and protecting the die, typically made of plastic or ceramic; (3) a metal leadframe having individual leads whose inner lead portions are housed within the encapsulation adjacent to the I/O pads of the die and whose outer lead portions protrude through the encapsulation to provide means for connection to a circuit board; and (4) thin metallic connecting wires within the encapsulation which connect the I/O pads of the die with the inner lead portions of the leads.

The connection of the metallic connecting wires to the I/O pads and the inner lead portions is typically accomplished by a process known as "ball bonding", which involves (1) feeding the connecting wire through a capillary, which runs through the tip of a bonding tool, until the end of the wire extends slightly past the tip, (2) forming a metallic "ball" on the end of the wire (e.g., by means of capacitance discharge or a small hydrogen torch), (3) using the bonding tool to thermosonically or ultrasonically weld the metallic ball to an I/O pad, (4) moving the bonding tool capillary tip into contact with a desired inner lead portion, thereby extending additional connecting wire through the capillary and beyond the tip, (5) thermosonically "wedge bonding" that portion of the wire immediately adjacent the tip to the inner lead portion, and (6) clamping and/or lifting the bonding tool away from the bond so as to break the rest of the connecting wire off from the bond just formed, thus leaving a length of connecting wire bonded on one end to an I/O pad and on its other end to an inner lead portion. This connecting process is well known to those skilled in the art of integrated circuit design and manufacture, and is described, for example, by Jacobi in U.S. Patent No. 4,842,662.

Alternatively, some devices do not utilise the metal leadframes, connecting wires, or the bonding process of the first type of structure described above. Instead, these devices utilise a second type of structure which uses metallic "bumps" connected to the I/O pads, rather than wires. For example, in chip-on-board (COB) technology, a bumped IC chip is flipped and bonded to a matching circuit pattern on the substrate. Also, in tape-automated bonding (TAB) technology, a bumped IC is bonded to a matching TAB strip. These bonding techniques provide electrical connection means between the I/O pads and the substrate or TAB strip. These bumps are similar to the metallic "balls" formed in the "bonding" process of the first structure described above. However, in the presently described "bumping" process, once the balls are attached to an I/O pad, the ball is severed from the connecting wire, thus becoming a metallic "bump" on the I/O pad.

Whether an IC device utilises connecting wires as in the first type of structure, or bumps as in the second type, depends on how the device is designed to electrically connect to the circuit board. If the device will incorporate leads for connection to the board, then generally the connecting wire structure will be used; however, if the device will not utilise leads, then generally the bumping process will be used. (It should be noted that "connecting wire", as used in the present specification, has two meanings. First, it may mean the spooled supply of wire fed through the bonding tool capillary and used as a raw material in both the first and second types of device structures described above. Second, it may refer to the many individual lengths of wire used inside a device of the first type of structure described above, with each of these multiple lengths of wire being referred to as "connecting wires", since they each connect a chip I/O pad to an inner lead portion.)

The connecting wire used in the bonding and bumping processes described above is occasionally made of aluminium, nickel, or copper, but is most commonly composed of gold or a gold alloy. Typically the connecting wires and bumps are attached to their respective I/O pads and inner lead portions by thermal sonic welding, which utilises heat, pressure, and ultrasonic vibration to attach the wires or bumps. However, because the I/O pads are usually made of aluminium and the connecting wire is generally made of gold, various undesirable intermetallic compounds are unfortunately created at the interface between these two dissimilar metals. These intermetallics, such as Au₅Al₂ and AuAl₂, are often brittle and create stress that is detrimental to the mechanical strength of the bond. This stress, in conjunction with other stresses caused by thermal and loading differentials acting on the device, often accelerates failure of the device by creating Kirkendahl voids and other breakdowns in the weld between the aluminium I/O pads and gold connecting wires.

One way of addressing this problem is to interpose a layer of metal between the aluminium I/O pads and the gold bumps. This metal layer is typically composed of a metal such as tungsten, titanium, molybdenum, platinum, nickel, rhodium, silicon, beryllium, or the like, which bonds well to both the I/O material and the bump material, but which also serves as a barrier between the I/O and bump materials so as to prevent the formation of intermetallic compounds therebetween. One such method for doing this is disclosed in U.S. Patent No. 5,455,195 to Ramsey et al. (hereinafter Ramsey). Ramsey teaches a method for depositing a thin layer of palladium or chromium over the aluminium I/O pads, so that when a gold or copper connecting wire is subsequently bonded to this layer no aluminium/gold or aluminium/copper intermetallics are formed. This layer of palladium or chromium may be formed by a wide variety of deposition or sputtering techniques, which typically involve masking the device or circuit board so as to expose only the I/O pads through the mask, electrodepositing or sputtering the intermediate layer material onto the I/O pads in a controlled manner, and removing the previously applied mask. Likewise, in U.S. Patent No. 3,942,187 to Gelsing et al. (hereinafter Gelsing), a method is taught for providing an intermediate layer sandwiched between a device's aluminium I/O pads and the corresponding gold or copper bumps formed over the pads. This method utilises such processes as vapour deposition, photoresist, etching, electrodeposition, RF or triode sputtering, chemical after-treatment, photolacquering, and the like in order to create the appropriate layers. In addition to the processes disclosed by Ramsey and Gelsing, there are other known methods similar to Ramsey and Gelsing for interposing an intermediate metallic layer between the I/O pads and the metallic connecting wire bumps.

However, all of the prior art methods require that the intermediate layer be produced off-line; that is, they must be produced by a separate process before the actual wire bonding process is performed. Furthermore, these methods also involve costly, time-consuming, and rather complicated multistep processes for providing this intermediate metallic layer, requiring such steps as prepping, masking, plating, electrodeposition or sputtering, demasking, cleaning, and the like. Moreover, often the use of harsh chemicals and solvents are required for these steps. It would therefore be desirable to provide a quick, simple, and inexpensive on-line method for providing an intermediate metallic layer between the I/O pads and the connecting wire for avoiding the formation of undesirable intermetallic compounds therebetween. As used herein, "on-line" means that the intermediate metallic layer is formed during the normal pad-to-lead connecting steps, not as part of a separate process prior to the pad-to-lead connecting steps.
US Patent No 3 561 084 describes a connection between a lamp filament and a metal lead having at least a portion of gold at the surface. The filament is placed on the surface portion of the lead. A body of gold is placed on the filament and over the surface portion of the lead. The body of gold is heated to a temperature below its melting point and is subjected to a pressure great enough to cause the body of gold to surround the filament and to create a diffusion bond between the body of gold and the surface portion of the lead.
The Article "Bonding Wire Microelectronic Interconnections" by Gehman B L in the IEEE Transactions on Components, Hybrids and Manufacturing Technology, Vol. CHMT-3, Nr. 3, pages 375-383, Sept. 1980 describes a method of making electrical contacts to semiconductor materials. A small ball is formed at the end of a connecting wire in conventional manner. The ball is brought into contact with an appropriate metal or metal alloy and the ball picks up the metal or metal alloy. This metal or metal alloy softens and remains in a molten state due to the elevated temperature of the tip of connecting wire. To form the contact, the ball is lowered onto the desired contact site and solidifies on the cold surface. The contact is made without compression, additional heating or ultrasonic bonding techniques.

The present invention provides a method for avoiding the formation of intermetallic compounds by on-line doping of metallic connecting wire for use in wire bonding and wire bumping of integrated circuit components.

A method according to the present invention comprises the steps of providing a bonding apparatus comprising a bonding tool, the bonding tool having a tip through which a capillary runs, such that metallic connecting wire may be fed through the tip; extending an end of the connecting wire a predetermined length beyond the tip; bringing the end of the wire into contact with dopant material and applying predetermined amounts of pressure, heat, and ultrasonic vibration to the end of the wire for a predetermined amount of time to form a doped area on the end of the wire; and bringing the doped area on the end of the wire into contact with a bonding area on the integrated circuit and applying predetermined amounts of pressure, heat, and ultrasonic vibration to the end of the wire for a predetermined amount of time to form a bond to the bonding area with dopant material sandwiched therebetween.
The method may include wedge bonding the connecting wire to a second bonding area on an integrated circuit.
Additionally, the method may also include the step of forming a metallic ball on the end of the connecting wire prior to forming the doped area on the end of the wire.
This method may use an apparatus comprising a connecting wire bonding tool, means for on-line doping of the connecting wire, and means for controlling the bonding and doping of the wire, all situated on a work table having a stanchion portion and a platen portion. The bonding tool comprises: a tip; a capillary formed in the tip, through which metallic connecting wire may be fed; and means for bonding the connecting wire. This means for bonding may include means for thermal sonic bonding, thermal compression bonding, or ultrasonic bonding. The means for on-line doping comprises a dopant target carried on a holder, the target having dopant material removably deposited thereon, with the holder being carried on the platen portion of the work table. The means for controlling the bonding and doping of the wire, in the case of thermal sonic bonding for example, comprises means for controlling the time, force, temperature, and ultrasonic vibration used doping and bonding the wire. The apparatus may further include means for forming a ball on the end of the connecting wire close to the bonding tool tip (such as by capacitance discharge), means for clamping and/or cutting the wire proximate the tip of the bonding tool, and microprocessor or other means for controlling the movement among the various elements of the apparatus.

It is an advantage of the present invention that an intermediate layer of dopant material is provided between a device's I/O pads and the dissimilar-metal connecting wire, by means of doping the wire on-line immediately prior to its connection to an I/O pad.

It as a further advantage that the present invention provides a quick, simple, and inexpensive means for such on-line doping of connecting wire.

The invention will now be described further, by way of example, with reference to the accompanying drawings, in which:
FIG. 1 is a perspective view of a typical integrated circuit component;
FIG. 2 is a cross-sectional end view of an integrated circuit component along line 2-2 of-FIG. 1;
FIG. 3 is a partially cut away top view of a portion of an integrated circuit component along line 3-3 of FIG. 2;
FIG. 4 is a cross-sectional elevation view of a portion of an integrated circuit component along line 4-4 of FIG. 3;
FIGS. 5A-5J show the steps in the method of the present invention;
FIGS. 6A-6B show steps in the method of wedge bonding the connecting wire end;
FIG. 7 shows an apparatus for on-line doping of metallic connecting wire according to one embodiment of the present invention; and
FIG. 8 shows an apparatus for on-line doping of metallic connecting wire according to an alternative embodiment of the present invention.

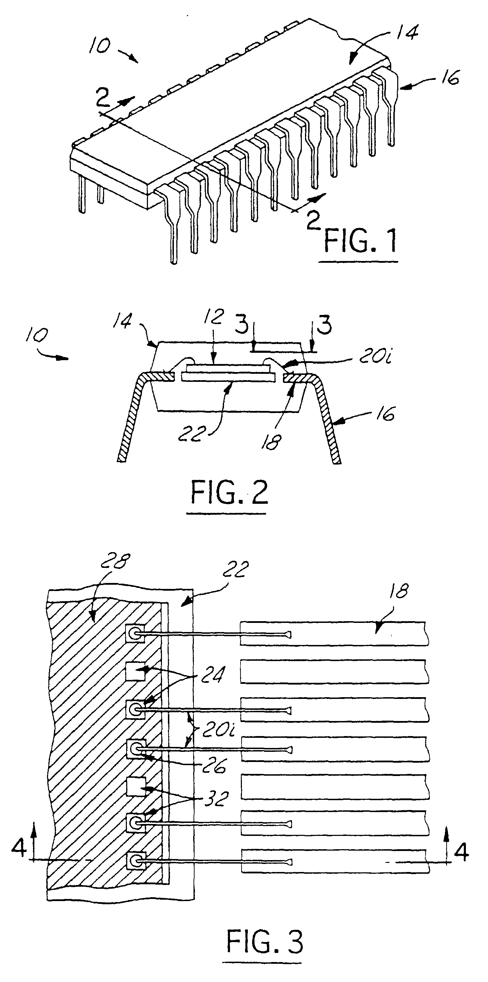

Referring now to the drawings, FIG. 1 shows a typical dual in-line package (DIP) integrated circuit device 10 which uses the wire bonding process described above. The component includes an encapsulation 14, which protects the internal circuitry of the device, as well as metal leads 16 which connect the internal circuitry of the device to the circuitry of the printed circuit board (not shown). Note that while a DIP is used here and in some of the following figures for the purpose of illustration, the present invention may apply to many other types of integrated circuit devices.

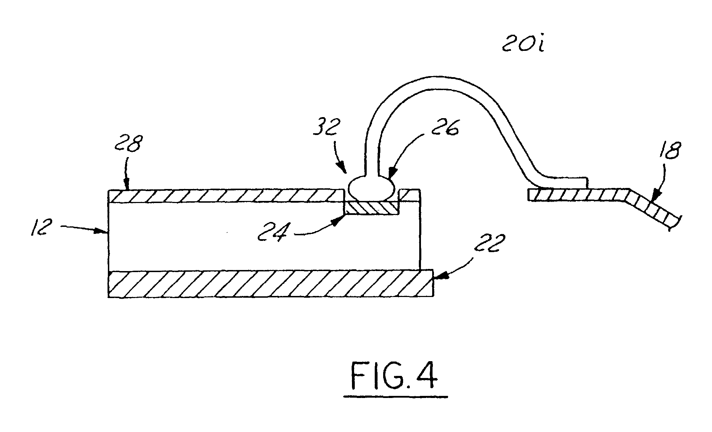

FIGS. 2-4 show further details of DIP 10. DIP 10 includes an integrated circuit die 12 situated upon a die pad 22, with the die 12 being connected to inner lead portions 18 of leads 16 via metallic connecting wires 20i. As shown in FIGS. 3 and 4, individual I/O pads 24 on a top surface of the die 12 are connected to the inner lead portions 18 via the connecting wires 20i. Note that the connecting wire 20i is "ball bonded" to the I/O pad 24 by a ball 26 of connecting wire material on one end of the wire 20i, with the other end of the wire being "wedge bonded" to the inner lead portion 18. As shown in FIG. 4, usually the die 12 is covered with a passivation layer 28 of SiO₂, silicon nitride, or the like which has holes 32 therein, these holes being situated generally over the I/O pads 24. In this arrangement the holes 32 allow connection of the connecting wire 20i to the pads while the passivation layer 28 electrically insulates the rest of the device circuitry.

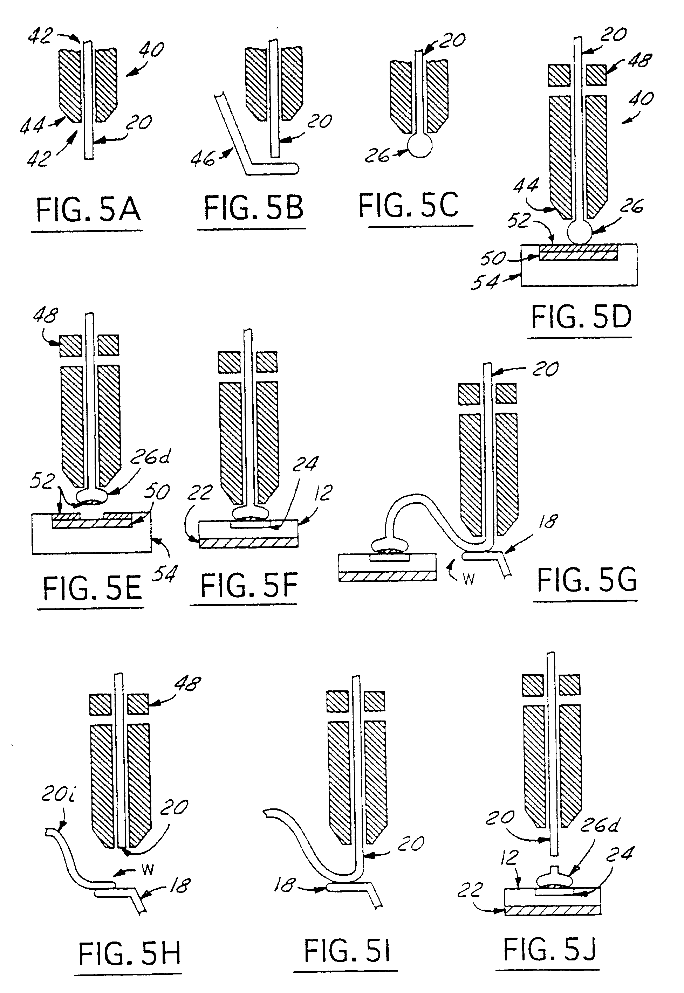

FIGS. 5A through 5I show the various steps involved in on-line doping of metallic connecting wire 20 according to the present invention, as well as showing how the doped wire is utilised in the ball bonding, wedge bonding, and bumping processes. First, the connecting wire 20 is fed through a capillary 42 formed in the tip 44 of a bonding tool 40, as shown in FIG. 5A. The bonding tool 40 is preferably capable of thermal sonic bonding, which utilises pressure, heat, and ultrasonic vibration in order to form a bond. However, it is alternatively possible to practice the present invention using means other than thermal sonic bonding, such as thermal compression bonding (using heat and pressure), ultrasonic bonding (using ultrasonic vibration and pressure), and the like. (Note that "ultrasonic vibration", as used in the present specification, includes both frequency and energy components, measured in kHz and watts, respectively. Also note that the supply of connecting wire is designated by the reference numeral 20, whereas the individual lengths of connecting wire which connect the I/O pads and inner lead portions are designated by the reference numeral 20i.)

After the connecting wire 20 is fed through the capillary 42 and past the tip 44 to a predetermined length, a ball 26 of connecting wire material may be formed, as shown in FIGS. 5B and 5C. The "predetermined length" of wire 20 fed past the tip 44 is generally that length of wire that will allow the ball 26 to be formed close to the tip 44 and with the minimal amount of wire being wasted in the ball forming step. FIG. 5-B shows an electric flame-off (EFO) device 46 brought into position close to the end of the wire 20, which causes the ball 26 to be formed when a capacitance discharge occurs between the EFO 46 and the wire 20. After the discharge, the EFO 46 may retract away from the tip 44. FIG. 5C shows the ball 26 formed close to the tip 44 following the discharge.

The steps shown in FIGS. 5A through 5C are well known to those skilled in the art relating to the present invention. However, the apparatus and wire doping step shown in FIG. 5D and the subsequent figures present novel features of the present invention not previously taught or suggested by the prior art. The apparatus according to the present invention includes the same bonding tool 40, connecting wire 20, and means 46 for forming a metallic ball 26 as described above, but further includes means for on-line doping of the ball 26 and/or connecting wire 20. This means for on-line doping comprises a dopant target 50 removably mounted on a holder 54, with dopant material 52 removably deposited on the target 50. The holder 54 is carried on a work table 72; the bonding tool 40 is disposed on the work table 72 as well. The dopant target 50 may be mounted to the holder 54 by a variety of means, including but not limited to clamps, pins, vacuum, and/or by being carried within a pocket formed on a top surface of the holder 54. The dopant target 50 is preferably made in such a way that the dopant material 52 adheres poorly to the target surface. This can be accomplished by providing the target 50 with a very smooth top surface onto which the dopant 52 is deposited, and/or by constructing the target's top surface (or the entire target 50) from a material to which the dopant 52 adheres poorly. For example, the target 50 may consist entirely of quartz or glass, or may have only a top surface portion of such material, with the remaining portion of the target 50 being constructed of metal, ceramic, or other material. The dopant material 52, used to minimise the formation of intermetallics between the wire 20 and the I/O pad 24, may be selected from one or more of the following metals: tungsten, titanium, palladium, chromium, beryllium, rhodium, platinum, nickel, and/or molybdenum. These metals are chosen for their ability to bond with both the metallic wire 20 (typically gold) and the metallic I/O pad 24 (typically aluminium), while also serving as a physical barrier between the metals of the wire 20 and I/O pad 24 so that intermetallic compounds do not form therebetween. The dopant material 52 may be placed on the surface of the target 50 by sputtering, electrodeposition, or other known means. Typically the dopant material 52 is deposited to a thickness of 1000 to 2000 angstroms (i.e., 0.1 to 0.2 microns). Dopant targets with dopant material thereon can be quickly and easily mass-produced and kept on hand, so that they can later be conveniently used in the on-line doping process whenever desired.

After the ball 26 is formed on the end of the connecting wire 20, the bonding tool 40 is lowered so that the ball 26 is brought into contact with the dopant material 52, as shown in FIG. 5D, in preparation for the wire doping step. The bonding tool 40 is pressed against the dopant material 52 with a predetermined amount of contact pressure, and the tool 40 is then ultrasonically excited with a predetermined profile of energy and frequency for a predetermined amount of time. Throughout this process, the dopant material 52 and the I/O pads 24 are preferably heated in order to facilitate the bonding taking place. Heating the dopant material 52 may be accomplished by heating the dopant target 50, the holder 54, and/or the work table 72, while heating the I/O pads 24 may be accomplished by heating the die 12, the holder 54, or whatever other member is carrying the die, depending upon how the particular apparatus is configured. Additionally, the bonding tool 40 may be heated as well. Typical bonding parameter ranges for bonding a common connecting wire size of 0.001 to 0.0013 inches (0.0025 to 0.0033 cms) are: 50 to 75 grams of bonding force, 0.75 to 1.00 watts of ultrasonic energy, ultrasonic frequency of 50 to 135 kHz, heating up the workpiece and/or wire to 180 to 200 degrees Celsius, and bonding for 30 to 50 milliseconds of bonding time.

Through this application of heat, pressure, and/or ultrasonic energy, the dopant material 52 in contact with the ball 26 becomes bonded to the ball. This creates a "doped ball" 26d on the tip 44 of the bonding tool 40. The bonding tool 40 is then lifted up from the surface of the target 50, as shown in FIG. 5E, thereby pulling away that portion of the dopant material 52 that was in contact with and bonded to the ball 26d. As noted above, the adhesion between the dopant 52 and the target 50 should be poor so that the dopant 52 may be easily lifted from the surface of the target by the ball 26d. Once the doped ball 26d is lifted from the target 50, a dopantless area, substantially conforming to the footprint of the ball 26d, will be left behind on the surface of the target. In subsequent doping steps, the bonding tool 40 may be positioned over other portions of the target surface where dopant material 52 still remains (i.e., areas other than those dopantless footprint areas resulting from previous doping steps). Thus, each successive doping step will utilise a different area of the target surface, so that eventually the entire doped surface of the target 50 may be used, thereby maximising the yield (and minimising any waste) associated with the doping process.

Once the doped ball 26d is formed, the bonding tool 40 and die 12 are positioned such that the doped ball 26d is brought into contact with the I/O pad 24 in preparation for the ball bonding step, as shown in FIG. 5F. The bonding tool is activated using substantially the same bonding parameter settings as in the previous wire doping step. This causes the doped ball 26d to be ultrasonically bonded to the I/O pads 24 with the dopant material 52 being sandwiched therebetween.

Next, the bonding tool 40, die 12, and inner lead portions 18 are positioned such that the tip 44 is brought into contact with an inner lead portion 18, thereby extending additional connecting wire 20 through the capillary 42 and beyond the tip 44, in preparation for the wedge bonding step illustrated in FIG. 5G. The bonding tool is then activated using substantially the same bonding parameter settings as in the previous wire doping step and ball bonding step, thereby bonding the wire 20 to an inner lead portion 18 and defining a wedge bonded area W thereat. At this point, the on-line doping cycle is completed by performing either one of the following two sequences of final steps. In the first sequence, clamping means 48 is actuated, which prevents the passage of wire 20 through the capillary 42, and the bonding tool 40 is lifted away from the inner lead portion 18, as shown in FIG. 5H. This severs the supply of connecting wire 20 from the wedge bonded area W, leaving a discrete length of connecting wire 20i ball bonded on one end to an I/O pad 24 and wedge bonded on the other end to an inner lead portion 18. The clamping means 48 is then de-actuated and the connecting wire 20 fed through the capillary 42 past the tip 44 to the aforementioned predetermined length in preparation for repeating the on-line doping and bonding cycle. Alternatively, in the second sequence of final steps the bonding tool 40 is lifted up from the wedge bonded area W to a predetermined height without clamping means 48 being actuated, as illustrated in FIG. 5I. Once this height is achieved, the clamping means 48 is then actuated and the bonding tool 40 lifted, thereby causing the wire 20 to be severed from the wedge bonded area W. The predetermined height to which the bonding tool 40 is lifted is such that the aforementioned predetermined length of wire 20 extends beyond the tip 44 after the wire 20 is severed from the wedge bonded area W. As an additional step to either of the foregoing two final sequences, a cutting means (not shown) may be actuated in order to-sever the supply of wire 20 from the wedge bonded area W. The cutting means may be used with or without the clamping means 48.

Note that no dopant material 52 is used in the wedge bonding step. This is because the typical arrangement is to use an aluminium I/O pad 24, gold connecting wire 20, and gold-plated inner lead portions 18. The typical pad-to-wire connection involves aluminium-to-gold bonding wherein intermetallic compounds may be created, so the dopant 52 is used in this step; however, the wire-to-lead connection typically involves gold-to-gold bonding, wherein no intermetallics are created, so no dopant 52 is required in this step.

The foregoing paragraphs describe the wire doping, ball bonding, and wedge bonding steps and apparatus to be used for connecting I/O pads 24 to inner lead portions 18. Additionally, the present invention may be applied to the process of wire bumping. This process involves the same process described above relating to wire doping and ball bonding, as shown in FIGS. 5A through 5F. However, after the doped ball 26d is bonded to the I/O pad 24, the supply of connecting wire 20 is severed from the ball 26d using the clamping means 48 and/or cutting means according to either of the two sequences of final steps mentioned above. This leaves a doped ball 26d bonded to the I/O pad 24 as shown in FIG. 5J, without the length of connecting wire 20i or wedge bonded area W described in the wedge bonding process above.

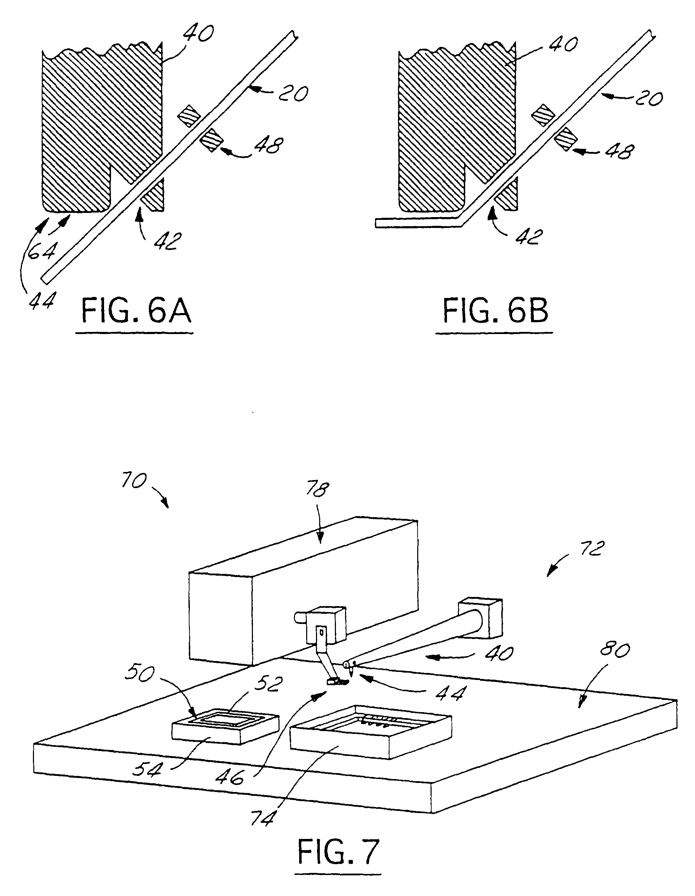

Furthermore, the present invention may also be applied to the process of wedge/wedge bonding. In this process, no ball 26 is formed. Rather a small length of connecting wire 20 is passed through a capillary 42 of a bonding tool 40 to a predetermined length beyond a bonding face 64 on the distal tip 44 of the tool 40, as in FIG. 6A. Then, this length of wire is bent so as to lie substantially against the bonding face 64 as shown in FIG. 6B. This is done either by using a deflection means (not shown) that is brought into contact with the end of the wire 20 or by moving the tool 40 so as to bend the length of wire against some surface. (Note that the capillary 42 may lie at an angle with the longitudinal axis of the bonding tool tip 44, in order to facilitate deflection of the connecting wire 20 against the bonding face 64. However, the capillary 42 may also lie parallel to or even collinear with the tip's longitudinal axis.) Then, the bent end of the wire 20 is brought into contact with the dopant 52 on the dopant target 50 and the end of the wire is doped by providing heat, force, and/or ultrasonic energy as in the ball doping process described above. This doped end of the wire 20 is then wedge bonded to a first bonding location. For example, a doped end of a gold wire may be wedge bonded to an aluminium I/O pad, or a doped end of an aluminium wire may be wedge bonded to a gold-plated inner lead portion. Following this doped wedge bond, a second, undoped wedge bond is made with a second bonding location (e.g., an aluminium wire is wedge bonded to an aluminium I/O), after which the supply of connecting wire 20 is severed from the second wedge bond using the clamping means 48 and/or the cutting means in conjunction with either of the two sequences of final steps described above.

FIG. 7 shows an apparatus 70 according to one configuration of the present invention for on-line doping of metallic connecting wire 20. The apparatus 70 includes several elements previously described, such as: a holder 54 which carries a dopant target 50 with dopant material 52 removably deposited thereon; a bonding tool 40 having a tip 44 and a capillary 42 (not shown) running through the tip; a supply of metallic connecting wire 20 (not shown) feedable through the capillary 42; and an integrated circuit workpiece 74, which may comprise, for example, an integrated circuit die 12 having aluminium I/O pads 24, and metal leads 16 having gold-plated inner lead portions 18. The apparatus 70 further includes a work table 72 comprising a stanchion portion 78 and a platen portion 80, wherein the platen portion 80 has a generally planar top surface on which the holder 54 may be carried. The platen portion top surface thus defines a horizontal plane having "x" and "y" directions, and a vertical "z" direction orthogonal to this plane. Additionally, the apparatus 70 also includes a microprocessor or other means (not shown) for controlling the process parameters, sequence of movements, and actions involved in the bonding and doping steps described above.

At least three different configurations of the apparatus 70 are possible. These configurations are determined by the movability of the holder 54, the bonding tool 40, and the platen portion 80, as described below.

In a first configuration, the holder 54 and workpiece 74 are carried on the platen portion 80 of the work table 72 as shown in FIG. 7. The bonding tool 40 is also movably disposed on the work table 72 (for example, to the stanchion portion 78), and is indexable the vertical (z) direction between a first raised stand-by position and a second lowered bonding position. The bonding tool 40 may also be capable of indexing to a third middle wire-extending position, situated at a predetermined vertical distance between the first raised standby and second lowered bonding positions. In the raised stand-by position, no doping or bonding occurs, although such steps as ball forming (for subsequent ball bonding) or wire deflecting (for subsequent wedge bonding) may occur. The lowered bonding position is used for successive doping and bonding steps. The middle wire-extending position is utilised when the bonding tool 40 is moved thereto immediately following a ball bonding step, so as to extend connecting wire 20 through the capillary 42 past the tip 44 in preparation for immediately subsequent wedge bonding. Finally, the platen portion 80 is movable within a horizontal (x,y) plane substantially parallel to the generally planar top surface of the platen portion 80 between a fourth position, wherein the dopant target 50 is positioned beneath the bonding tool 40, and a fifth position, wherein the workpiece 74 is positioned beneath the bonding tool 40.

In this configuration, the bonding tool 40 may initially be in the first raised position wherein a ball 26 is formed, whereupon the platen 80 is moved into the fourth position wherein the dopant target 50 is placed under the bonding tool 40. Then, the bonding tool would move into the second lowered bonding position, whereupon the ball 26 is placed in contact with the dopant target 50 and the bonding means of the bonding tool 40 is activated, thereby forming a doped ball 26d. The bonding tool 40 would then return to the first raised position, and the platen 80 would move to the fifth position wherein the workpiece 74 is placed under the bonding tool 40. Then, the bonding tool would again move into the second lowered position where the doped ball 26d is placed into contact with a desired location on the workpiece (e.g., a particular I/O pad), whereupon the bonding means would be activated, thereby connecting the doped ball 26d to the workpiece 74. The bonding tool 40 would then be brought into the third middle wire-extending position and the platen 80 would then be moved into a slightly different fifth position wherein a different desired location on the workpiece 74 (e.g., an inner lead portion) is brought under the bonding tool 40, after which the bonding tool would be lowered into contact with this different location on the workpiece, wedge bond the wire 20 to this location, sever the supply of wire 20 from the individual length of connecting wire 20i, and return to the first raised position in order to repeat the above process. However, in successive returns to the target 50, the ball 26 will be placed on an area on the surface of the target different from any previously used area. Likewise, when the bonding tool 40 is subsequently brought into contact with the workpiece 74, each successive trip brings the bonding tool 40 into contact with a location on the workpiece different from that of previous trips (unless any given location on the workpiece 74 is to have more than one bond made to it, as in the case where a single I/O pad 24 might be wire bonded to two or more inner lead portions 18). In this way, the entire surface of the target 50 can be used over the course of successive doping steps, and different locations on the workpiece can be connected together or bumped as desired.

In a second configuration, the platen 80 carrying the workpiece 74 and dopant target holder 54 is fixed, and the bonding tool 40 is movable in three-dimensional (x,y,z) space, as illustrated in FIG. 7. In this configuration, the bonding tool 40 initially brings the ball 26 into contact with a first area on the surface of the dopant target 50, whereupon thermal sonic or other bonding means will be activated and a doped ball 26d formed. Then the bonding tool lifts the doped ball 26d and places it on an I/O pad 24 on the workpiece 74, whereupon the bonding means would again be activated and the doped ball 26d would become bonded to the I/O pad 24. After this, the bonding tool 40 moves its tip 44 over to and in contact with the inner lead portion 18 of a metallic lead 16, whereupon the bonding means would once again be activated and an undoped wedge bond formed thereat. Then, the clamping means 48 and/or cutting means acts in conjunction with the lifting bonding tool 40 so that the wire 20 is severed proximate the wedge bond, thereby leaving an individual length of connecting wire 20i connected between the I/O pad 24 and inner lead portion 18.

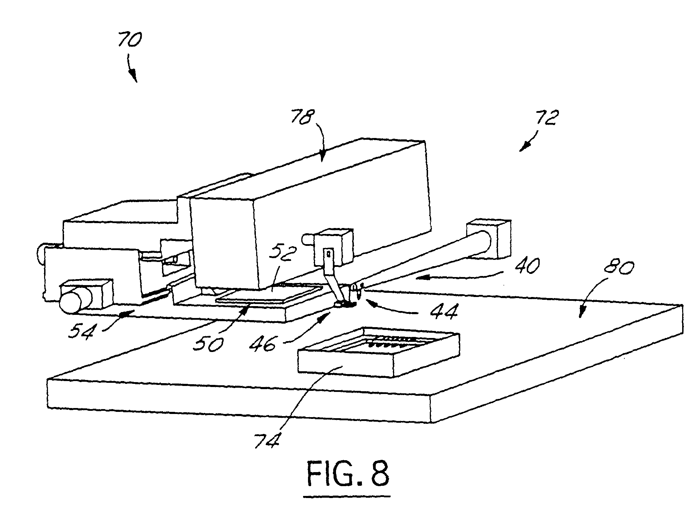

A third configuration, as shown in FIG. 8, is similar to the first, in that the bonding tool 40 is indexable in a vertical (z) direction between a first raised stand-by position, a second lowered bonding position, and a third middle wire-extending position. Additionally, the bonding tool 40 is also indexable to a fourth middle doping position. The platen 80 is movable within a horizontal (x,y) plane. However, unlike the first configuration, the platen 80 carries only the workpiece 74, and the holder 54 is movably mounted to the stanchion 78 such that the holder 54 may move within a horizontal plane substantially parallel to the top surface of the platen 80 between a first bonding position, wherein the holder 54 is positioned so as to present the target 50 beneath the bonding tool 40 in preparation for doping, and a second retracted position, wherein the holder 54 is retracted away from the first position so as not to interfere with subsequent process steps.

In this configuration, the bonding tool 40 is initially in the first raised position wherein a ball 26 is formed, whereafter the holder 54 is moved into the first bonding position such that the dopant target 50 is positioned beneath the bonding tool 40. Then, the bonding tool 40 is moved into the fourth middle doping position, wherein the ball 26 is placed in contact with the dopant target 50 and the bonding means of the bonding tool 40 is activated, thereby forming a doped ball 26d. The bonding tool 40 then returns to the first raised stand-by position, whereafter the holder 54 would move to the second retracted position so as not to interfere with any subsequent process steps or movements of apparatus elements. Next, the platen 80 is moved so as to present a desired portion of the workpiece 74 beneath the bonding tool 40. (It should be noted that this step of positioning the workpiece 74 may be performed earlier.) Then, the bonding tool 40 is indexed into the second lowered bonding position where the doped ball 26d is placed into contact with a desired location on the workpiece (e.g., a particular I/O pad), whereupon the bonding means is activated, thereby bonding the doped ball 26d to the workpiece 74. Finally, the bonding tool 40 is moved into the third middle wire-extending position and the platen 80 is moved into a slightly different position wherein a different desired location on the workpiece 74 (e.g., an inner lead portion) is brought beneath the bonding tool 40, after which the bonding tool 40 is again indexed into the second lowered bonding position, bringing the connecting wire 20 into contact with this different location on the workpiece. The wire 20 is then bonded to this location, the supply of wire 20 is severed from the individual length of connecting wire 20i, and the bonding tool 40 is returned to the first raised stand-by position in preparation for repeating the above process.

The three foregoing configurations of an apparatus for on-line doping of metallic connecting wire according to the present invention can be summarised and compared using the following table:

| Config. | Platen (72) | Holder (54) | Tool (40) | FIG. |
|---|---|---|---|---|
| First | x,y | on Platen | z | 7 |
| Second | fixed | on Platen | x,y,z | 7 |
| Third | x,y | x,y | z | 8 |

Various other modifications are possible within the scope of the present invention. For example, the means for producing the ball on the end of the connecting wire may include the use of a torch, such as a hydrogen torch. Also, the bonding tool may be movably disposed on the platen portion rather than on the stanchion portion of the work table, or to some other, additional portion. Likewise, in the third configuration, the holder may be movably mounted to the platen or to some other, additional portion of the work table. Furthermore, note that in the first and second configurations the holder may be combined so as to form a single platen member, while in second configuration the stanchion and platen may be combined to form a single work table member. Moreover, it is clear that the three configurations may each be used for ball bonding, wedge bonding, and wire bumping. Additionally, it should also be clear that the bonding tool, movable platen, and movable holder may be movable or indexable to other positions in addition to those described above, such as loading/unloading positions wherein connecting wire, workpieces and/or holders, and targets, respectively, may be loaded/unloaded.

## Claims

1. A method for bonding a metallic connecting wire to a bonding area of an integrated circuit (10), comprising the steps of:
providing a bonding apparatus (70) comprising a bonding tool (40), said bonding tool having a tip (44) through which a capillary (42) runs, such that metallic connecting wire (20) may be fed through said tip;
extending an end of the connecting wire (20) a predetermined length beyond the tip (44) of said bonding tool (40);
bringing the end of said wire into contact with dopant material (52) and applying predetermined amounts of pressure, heat, and ultrasonic vibration to said end of the wire (20) for a predetermined amount of time to form a doped area on the end of said wire (20); and
bringing the doped area on the end of said wire into contact with a first bonding area (24) on the integrated circuit (10) and applying predetermined amounts of pressure, heat, and ultrasonic vibration to said end of the wire for a predetermined amount of time to form a bond to the first bonding area (24) with dopant material sandwiched therebetween.

2. A method as claimed in claim 1, further comprising the step of forming a metallic ball (26) on the end of the connecting wire (20) before said forming step.

3. A method as claimed in claim 2, wherein said step of forming a metallic ball (26) on the end of the connecting wire (20) includes applying a high voltage between the end of the connecting wire (20), positioning an electric flame-off device (46) adjacent said end, and causing an electric discharge therebetween.

4. A method as claimed in claim 1, further including the steps of:
bringing said tip (44) into contact with a second bonding area (18) on the integrated circuit, thereby extending additional connecting wire through said capillary (42) and
beyond said tip (44), and applying predetermined amounts of pressure, heat, and ultrasonic vibration to said end of the wire for a predetermined amount of time to wedge bond the connecting wire (20) to the second bonding area (18); and
retracting said tip (44) from the second bonding area (18), thereby leaving a length of connecting wire having a first end in doped connection with the first bonding area (24) and having a second end in undoped connection with the second bonding area (18).

5. A method as claimed in claim 4, further including the step of severing the connecting wire (20) from the doped metallic ball (26) after said wedge bonding step and before said retracting step.

6. A method as claimed in claim 4, further including the step of clamping said wire (20) relative to said tip (44) after said wedge bonding step and before said retracting step.

7. A method according to claim 1, wherein said dopant material is made of an alloy including at least one metal selected from the group consisting of tungsten, titanium, palladium, chromium, molybdenum, rhodium, nickel, silicon, and beryllium.

8. A method as claimed in claim 1, wherein said dopant material is a removable deposit on a top surface of a dopant target (50).

9. A method as claimed in claim 1, wherein said bonding apparatus comprises:
a work table (72) having a stanchion portion (78) and a platen portion (80), said platen portion (80) having a generally planar top surface;
a bonding tool (40) disposed on said work table (72) and including means for bonding said metallic connecting wire to an integrated circuit workpiece, said workpiece being carried on said top surface of said platen portion;
means for doping of said end of said connecting wire with dopant material, said means being carried on said work table (72); and
microprocessor means for controlling said means for bonding and said means for doping.

## Patentansprüche

1. Verfahren zum Bondieren eines metallenen Anschlußdrahtes an einen Bondierbereich einer integrierten Schaltung (10), folgende Schritte aufweisend:
Stellen eines Bondiergerätes (70) mit einem Bondierwerkzeug (40), wobei besagtes Bondierwerkzeug eine Spitze (44) aufweist, durch welche ein Kapillarröhrchen (42) läuft, so daß metallener Anschlußdraht (20) durch besagte Spitze zugeführt werden kann;
Ausziehen eines Endes des Anschlußdrahtes (20) um eine vorgegebene Länge über besagte Spitze (44) des besagten Bondierwerkzeuges (40) hinaus;
Vorschieben des Endes des besagten Drahtes bis in Kontakt mit Dotierstoff (52) und Aufbringen von Druck, Wärme und Ultraschallschwingungen in vorgegebener Höhe und für einen vorgegebenen Zeitraum auf besagtes Ende des Drahtes (20), zur Bildung eines dotierten Bereiches auf diesem Ende des besagten Drahtes (20); und
Verschieben des dotierten Bereiches am Ende des besagten Drahtes bis in Kontakt mit einem ersten Bondierbereich (24) auf der integrierten Schaltung (10) und Aufbringen von Druck, Wärme und Ultraschallschwingungen in vorgegebener Höhe und für einen vorgegebenen Zeitraum auf besagtes Drahtende, zur Herstellung einer Verbindung mit dem ersten Bondierbereich (24), wobei Dotierstoff zwischen den beiden eingeschlossen ist.

2. Verfahren nach Anspruch 1, vor besagtem Bildungsschritt außerdem den Schritt der Bildung eines metallenen Kügelchens (26) am Ende des Anschlußdrahtes (20) aufweisend.

3. Verfahren nach Anspruch 2, worin besagter Schritt der Bildung eines metallenen Kügelchens (26) am Ende des Anschlußdrahtes (20) das Anlegen einer hohen Spannung an diesem Ende des Anschlußdrahtes (20) beinhaltet, das Positionieren einer elektrischen Funkenüberschlagvorrichtung (46) in unmittelbarer Nähe des besagten Endes, und Erzeugen einer elektrischen Entladung zwischen den beiden.

4. Verfahren nach Anspruch 1, außerdem folgende Schritte aufweisend:
Verschieben der besagten Spitze (44) bis in Kontakt mit einem zweiten Bondierbereich (18) auf besagter integrierter Schaltung, so daß mehr Anschlußdraht durch besagtes Kapillarröhrchen (42) und über besagte Spitze (44) hinaus gezogen wird, und Anlegen von Druck, Wärme und Ultraschallschwingungen in vorgegebener Höhe und für einen vorgegebenen Zeitraum an besagtem Drahtende, so daß der Anschlußdraht (20) an dem zweiten Bondierbereich (18) in einem *Wedge-Bond* befestigt wird; und
Zurückziehen der besagten Spitze (44) von besagtem zweitem Bondierbereich (18), so daß ein Stück Anschlußdraht zurückbleibt, dessen erstes Ende in einer dotierten Verbindung mit dem ersten Bondierbereich (24) verbunden ist, und dessen zweites Ende in einer undotierten Verbindung mit dem zweiten Bondierbereich (18) verbunden ist.

5. Verfahren nach Anspruch 4, außerdem den Schritt der Trennung des Anschlußdrahtes (20) von dem dotierten Metallkügelchen (26) nach besagtem *Wedge-Bonding*-Schritt und vor besagtem Rückzugsschritt beinhaltend.

6. Verfahren nach Anspruch 4, außerdem den Schritt des Klemmens des besagten Drahtes (20) relativ zu besagter Spitze (44) beinhaltend, und zwar nach besagtem *Wedge-Bonding*-Schritt und vor besagtem Rückzugsschritt.

7. Verfahren nach Anspruch 1, worin besagter Dotierstoff aus einer Legierung besteht, welche mindestens ein Metall beinhaltet, das aus einer Gruppe aus Wolfram, Titan, Palladium, Chrom, Molybdän, Rhodium, Nickel, Silizium und Beryllium gewählt ist.

8. Verfahren nach Anspruch 1, worin besagter Dotierstoff ein abtragbarer Auftrag auf einer Oberseite eines Dotierstoff-Targets (50) ist.

9. Verfahren nach Anspruch 1, worin besagtes Bondiergerät folgendes aufweist:
einen Tisch (72) mit einem Ständerteil (78) und einem Bearbeitungsplattenteil (80), wobei besagter Bearbeitungsplattenteil (80) eine allgemein ebene Oberseite hat;
ein Bondierwerkzeug (40), welches auf besagtem Tisch (72) angeordnet ist und Mittel zum Bondieren des besagten metallenen Anschlußdrahtes an einem Werkstück in Form einer integrierten Schaltung aufweist, wobei besagtes Werkstück auf besagter Oberseite des besagten Bearbeitungsplattenteiles gelagert ist;
Mittel zum Dotieren des besagten Endes des besagten Anschlußdrahtes mit Dotierstoff, wobei besagte Mittel auf besagtem Tisch (72) gelagert sind; und
Mikroprozessormittel zur Steuerung der besagten Mittel zum Bondieren und der besagten Mittel zum Dotieren.

## Revendications

1. Procédé de soudage d'un fil de connexion métallique sur une zone de soudage d'un circuit intégré (10), comprenant les étapes consistant à :
fournir un appareil de soudage (70) comprenant un outil de soudage (40), ledit outil de soudage comportant une pointe (44) au travers de laquelle s'étend un tube capillaire (42), de sorte qu'un fil de connexion métallique (20) peut être avancé par l'intermédiaire de ladite pointe,
étendre une extrémité du fil de connexion (20) sur une longueur prédéterminée au-delà de la pointe (44) dudit outil de soudage (40),
amener la pointe dudit fil jusqu'en contact avec un matériau de dopant (52) et appliquer des valeurs de pression prédéterminées, de la chaleur et une vibration ultrasonore à ladite extrémité du fil (20) pendant un intervalle de temps prédéterminé afin de former une zone dopée sur l'extrémité dudit fil (20), et
amener la zone dopée sur l'extrémité dudit fil jusqu'en contact avec une première zone de soudage (24) sur le circuit intégré (10) et appliquer des valeurs de pression prédéterminées, de la chaleur, et une vibration ultrasonore à ladite extrémité du fil pendant un intervalle de temps prédéterminé afin de former une liaison avec la première zone de soudage (24), le matériau de dopant étant pris en sandwich entre ceux-ci.

2. Procédé selon la revendication 1, comprenant en outre l'étape consistant à former une bille métallique (26) à l'extrémité du fil de connexion (20) avant ladite étape de formation.

3. Procédé selon la revendication 2, dans lequel ladite étape de formation d'une bille métallique (26) à l'extrémité du fil de connexion (20) comprend l'application d'une haute tension par rapport à l'extrémité du fil de connexion (20), le positionnement d'un dispositif d'inflammation électrique (46) à proximité de ladite extrémité, et la production d'une décharge électrique entre ceux-ci.

4. Procédé selon la revendication 1, comprenant en outre les étapes consistant à :
amener ladite pointe (44) jusqu'en contact avec une seconde zone de soudage (18) sur le circuit intégré, en étendant ainsi un fil de connexion supplémentaire au travers dudit tube capillaire (42) et au-delà de ladite pointe (44), et appliquer des valeurs de pression prédéterminées, de la chaleur, et une vibration ultrasonore à ladite extrémité du fil pendant un intervalle de temps prédéterminé afin de souder par thermocompression le fil de connexion (20) à la seconde zone de soudage (18), et rétracter ladite pointe (44) de la seconde zone de soudage (18), en laissant ainsi une longueur de fil de connexion ayant une première extrémité en connexion par dopage avec la première zone de soudage (24) et ayant une seconde extrémité en connexion non dopée avec la seconde zone de soudage (18).

5. Procédé selon la revendication 4, comprenant en outre l'étape consistant à couper le fil de connexion (20) de la bille métallique dopée (26) après ladite étape de soudage par thermocompression et avant ladite étape de retrait.

6. Procédé selon la revendication 4, comprenant en outre l'étape consistant à serrer ledit fil (20) par rapport à ladite pointe (44) après ladite étape de soudage par thermocompression et avant ladite étape de retrait.

7. Procédé selon la revendication 1, dans lequel ledit matériau de dopant est fait d'un alliage comprenant au moins un métal choisi à partir du groupe constitué du tungstène, du titane, du palladium, du chrome, du molybdène, du rhodium, du nickel, du silicium et de béryllium.

8. Procédé selon la revendication 1, dans lequel ledit matériau de dopant est un dépôt amovible sur une surface supérieure d'une cible de dopant (50).

9. Procédé selon la revendication 1, dans lequel ledit appareil de soudage comprend :
une table de travail (72) comportant une partie de colonne de soutien (78) et une partie de plateau (80), ladite partie de plateau (80) présentant une surface supérieure généralement plane,
un outil de soudage (40) disposé sur ladite table de travail (72) est comprenant un moyen destiné à souder ledit fil de connexion métallique à une pièce d'ouvrage de circuit intégré, ladite pièce d'ouvrage étant portée sur ladite surface supérieure de ladite partie de plateau,
un moyen destiné à doper ladite extrémité dudit fil de connexion avec un matériau de dopant, ledit moyen étant porté sur ladite table de travail (72), et
un moyen de microprocesseur destiné à commander ledit moyen destiné à souder et ledit moyen destiné au dopage.
